# EUROPÄISCHE PATENTSCHRIFT

(11) **EP 0 672 311 B1**
(45) Veröffentlichungstag und Bekanntmachung des Hinweises auf die Patenterteilung: **18.09.1996**
(21) Anmeldenummer: 94901869.1
(22) Anmeldetag: 24.11.1993
(51) Int. Cl.: H01S 3/085, H01S 3/103, H01S 3/101

(54) **ABSTIMMBARE OBERFLÄCHENEMITTIERENDE LASERDIODE**
TUNABLE SURFACE-EMITTING LASER DIODE
DIODE LASER ACCORDABLE A EMISSION DE SURFACE

(30) Priorität: 03.12.1992 EP 92120671
(43) Veröffentlichungstag der Anmeldung: 20.09.1995
(73) Patentinhaber: SIEMENS AKTIENGESELLSCHAFT, 80333 München (DE)
(72) Erfinder: KÖCK, Anton, D-81927 München (DE); GORNIK, Erich, D-80538 München (DE)
(86) Internationale Anmeldenummer: EP9303301
(87) Internationale Veröffentlichungsnummer: WO9413044

(56) Entgegenhaltungen:
- EP-A- 0 360 011
- EP-A- 0 442 002
- US-A- 4 874 953
- MICROELECTRONIC ENGINEERING Bd. 19, Nr. 1-4 , September 1992 Seiten 57 - 59; A. KÖCK et al :"Surface Emitting Semiconductor Laserdiodes Based on Surface Mode Emission"
- PROCEEDINGS OF THE INTERNATIONAL SOCIETY FOR OPTICAL ENGINEERING Bd. 1362 , Bellingham, US; Seiten 1 - 13 XP236368,E. GORNIK et al.:"Surface Plasmon Enhanced Light Emission in GaAs/AlGaAs Light Emitting Diodes"
- JAPANESE JOURNAL OF APPLIED PHYSICS. SUPPLEMENTS, 16TH INTERNATIONAL CONFERENCE ON SOLID STATE DEVICES AND MATERIALS, KOBE,30. September 1984 , Tokyo, JP;Seiten 141 - 144,Y. KAN et al.:"Beam-Scannable Light Source with the Grating Output Coupler"
- PATENT ABSTRACTS OF JAPAN,vol. 9, no. 280 (E-356)(2003) 8. November 1985;& JP-A-60 123 084

## Beschreibung

Die vorliegende Erfindung betrifft eine oberflachenemittierende Laserdiode, bei der unterschiedliche Abstrahlrichtungen realisierbar sind.

In der EP-A-0 442 002 ist ein strahlungserzeugendes Halbleiterbauelement beschrieben, bei dem an der Oberfläche des Halbleitermateriales räumliche periodische Strukturierungen vorhanden sind, die mit einem dünnen Metallfilm überzogen sind. An der Oberfläche dieses Metallfilmes werden Oberflachenplasmonpolaritonen durch in der aktiven Schicht erzeugte Photonen angeregt. Durch diese Anregung von Oberflachenmoden wird eine extrem gebündelte Abstrahlung von der Oberfläche erzielt. Oberflachenplasmonpolaritonen sind transversal elektrische (TE) oder transversal magnetische (TM) Oberflachenmoden, die sich an der Grenzfläche zweier verschiedener Medien ausbreiten können. Für die Anregung dieser Moden bedarf es einer geeigneten periodischen Strukturierung der Grenzfläche, die bei dem beschriebenen Bauelement durch eine z. B. durch Ätzen erzeugte räumliche Strukturierung der Halbleiteroberfläche ausgebildet ist. Die bei herkömmlichen strahlungserzeugenden Bauelementen auftretenden Verlustmechanismen, die den Wirkungsgrad begrenzen, können umgangen werden, wobei gleichzeitig eine deutlich verringerte Linienbreite des abgestrahlten Lichtes und eine drastische Erhöhung der externen Quantenausbeute erreicht wird. Die Abstrahlung erfolgt darüber hinaus mit einer definierten Polarisationsrichtung, die durch die Anordnung und Ausrichtung der periodischen Oberflächenstrukturierung festgelegt ist.

In der EP-A-0 360 011 ist eine abstimmbare DFB-Laserdiode beschrieben, bei der die aktive Schicht und die Abstimmschicht transversal zueinander angeordnet sind und über eine zwischenschicht, die sich dazwischen befindet, getrennt angesteuert werden können. Diese in der Fachwelt als TTG-DFB-Laserdiode bekannte Laserdiode existiert inzwischen in verschiedenen Modifikationen, die insbesondere verschiedene Anordnungen der für die Stromzuführungen erforderlichen Kontakte betreffen. Derartige Dioden lassen sich auf leitfähigen und auf semiisolierenden Substraten aufbauen. Die Schichtstruktur kann im einzelnen an die jeweiligen Erfordernisse, insbesondere bei der Herstellung hochintegrierter Bauelemente, angepaßt werden.

In der Veröffentlichung von A. Köck e. a: "Surface emitting semiconductor laserdiodes based on surface mode emission" in Micro Electronic Engineering 19, 57 bis 60 (1992) ist eine oberflächenemittierende Laserdiode beschrieben, bei der eine periodisch strukturierte Oberfläche entsprechend der Laserdiode der genannten EP-A-0 442 002 mit einem dünnen Metallfilm zur Anregung von Oberflächenplasmonpolaritonen bedeckt ist. Bei dieser Laserdiode besitzen die abgestrahlten Lichtbündel eine extrem enge Strahldivergenz. Bei den mit dieser Laserdiode durchgeführten Messungen wurde die Emissionswellenlänge durch eine geringfügige Änderung der Betriebstemperatur um 2 nm verändert und damit eine Änderung der Abstrahlrichtung um einen Winkel von 0,55° erreicht.

Aufgabe der vorliegenden Erfindung ist es, eine oberflächenemittierende Laserdiode anzugeben, die extrem gebündelt abstrahlt und deren Abstrahlrichtung ohne Veränderung des strukturellen Aufbaus oder der Anordnung der Diode variiert werden kann.

Diese Aufgabe wird mit der abstimmbaren Laserdiode mit den Merkmalen des Anspruches 1 gelöst. Weitere Ausgestaltungen ergeben sich aus den abhängigen Ansprüchen.

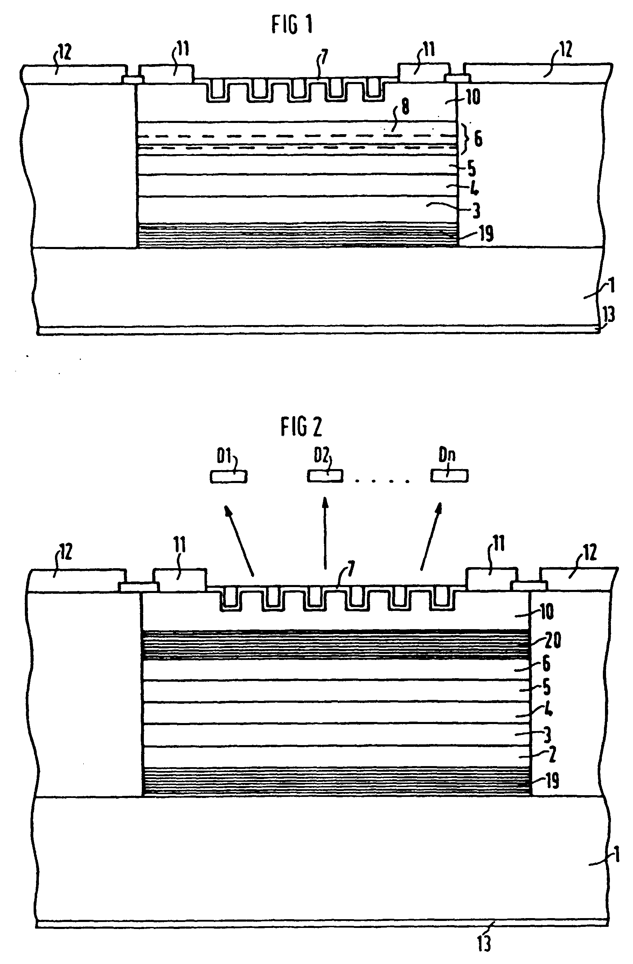

Die vorliegende Erfindung löst die gestellte Aufgabe durch die Kombination eines der TTG-Laserdiode ähnlichen Schichtaufbaus mit einer Oberflächengestaltung, die die Anregung von Oberflachenmoden gestattet. Diese erfindungsgemäße Laserdiode wird im folgenden anhand verschiedener Ausführungsbeispiele, die in den Figuren 1 bis 6 dargestellt sind, beschrieben.
- Fig. 1 bis 3: zeigen jeweils eine Ausführungsform der erfindungsgemäßen Laserdiode im Querschnitt.
- Fig. 4: zeigt einen Längsschnitt der in Fig. 3 dargestellten Ausführungsform.
- Fig. 5 und 6: zeigen jeweils Schnittaufsichten der Laserdioden der Figuren 1 bzw. 3.

Bei der erfindungsgemäßen Laserdiode ist transversal zu einer aktiven Schicht eine Abstimmschicht vorgesehen. Diese Abstimmschicht unterscheidet sich durch den Energiebandabstand des verwendeten Halbleitermateriales von der aktiven Schicht. Damit wird erreicht, daß in der Abstimmschicht keine Strahlung erzeugt wird. Die aktive Schicht und die Abstimmschicht sind zwischen dotierten Halbleiterschichten angeordnet, wobei diese Halbleiterschichten so dotiert sind, daß in die aktive Schicht und in die Abstimmschicht getrennt Ströme injiziert werden können. Zu diesem Zweck ist z. B. eine zwischen der aktiven Schicht und der Abstimmschicht angeordnete Zentralschicht für den einen Leitfähigkeitstyp dotiert, während zwei jeweils auf der gegenüberliegenden Seite der aktiven Schicht und der Abstimmschicht angeordnete Kontaktschichten für den entgegengesetzten Leitfähigkeitstyp dotiert sind. Wenn diese Zentralschicht und die beiden Kontaktschichten jeweils getrennt voneinander z. B. über leitfähig dotiertes Halbleitermaterial mit je einem Kontakt verbunden sind, können durch Anlegen geeigneter Potentiale an diese Kontakte unabhängig voneinander steuerbare Ströme an die aktive Schicht und an die Abstimmschicht angelegt werden. Damit läßt sich die Wellenlänge der in der aktiven Schicht erzeugten Strahlung abstimmen. Oberhalb des für Strahlungserzeugung in der aktiven Schicht vorgesehenen Bereiches ist die räumliche periodische Strukturierung in der Oberfläche des Halbleitermateriales angeordnet. An der Außenseite des dünnen darauf aufgebrachten Metallfilmes können dann bei Betrieb der Laserdiode Oberflachenmoden angeregt werden, die zu einer Lichtabstrahlung von der Oberfläche führen. Die Abstrahlrichtung hängt dabei von der Wellenlänge des Lichtes und der Periodenlänge der Strukturierung ab. Bei gegebener Periodenlänge kann daher die Abstrahlrichtung durch Ändern der Wellenlänge variiert werden.

Mittel zur Erzielung einer Laserresonanz umfassen mindestens eine parallel und bezüglich der Schichtebenen transversal zu der aktiven Schicht angeordnete Spiegelschicht und ggf. ein DFB-Gitter bzw. DBR-Gitter, das ebenfalls parallel und bezüglich der Schichtebenen transversal zu der aktiven Schicht angeordnet ist.

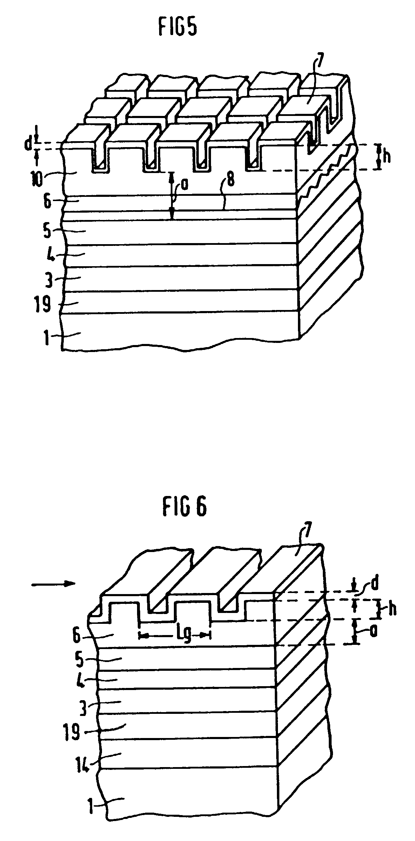

In Fig. 1 ist auf ein leitfähiges Substrat 1 eine Schichtfolge, die im Querschnitt gezeichnet ist, aufgebracht. Zunächst ist eine untere Spiegelschicht 19 aufgebracht. Darauf befinden sich nacheinander die Abstimmschicht 3, die Zentralschicht 4 und die aktive Schicht 5. Eine obere Kontaktschicht 6 enthält ein DFB-Gitter 8. Diese Kontaktschicht 6 ist durch eine Deckschicht 10 bedeckt, deren Oberfläche die räumliche periodische Strukturierung aufweist. Das DFB-Gitter 8 dient der Erzeugung einer Laserresonanz. Anstelle dieses DFB-Gitters 8 oder zusätzlich dazu können an den longitudinalen Begrenzungen der aktiven Schicht 5 Spiegelendflächen, ggf. mit darauf aufgebrachten Spiegelschichten zur Verspiegelung, vorhanden sein, so daß der Laserresonator ein Fabry-Perot-Laser ist. In Fig. 1 ist der Schichtaufbau streifenförmig und seitlich durch Halbleitermaterial begrenzt. Der Schnitt verläuft dabei quer zur Längsrichtung des Streifens. In der Deckschicht 10 befindet sich eine zweidimensional angeordnete periodische räumliche Strukturierung, wie sie ähnlich in Schrägaufsicht in Fig. 5 dargestellt ist. Auf dieser Strukturierung befindet sich ein dünner Metallfilm 7, der vorteilhaft z. B. Silber, Gold oder Aluminium ist. Die periodische Strukturierung kann auch direkt in der oberen Kontaktschicht 6 vorhanden sein. Die Deckschicht 10 ist dann überflüssig. Ebenso kann die Anordnung von aktiver Schicht 5 und Abstimmschicht 3 vertauscht sein, d. h. die Abstimmschicht ist dann bezüglich des Substrates 1 oberhalb der aktiven Schicht angeordnet. Ein DFB-Gitter 8 kann auch an anderer Stelle innerhalb der Schichtfolge angeordnet sein. Bei Vorhandensein einer oberen Spiegelschicht ist ein Gitter überflüssig. Es kann aber zusätzlich oder statt derer vorhanden sein, z. B. als DBR-Gitter. Zur Strominjektion kann zwischen der unteren Spiegelschicht 19 und der Abstimmschicht 3 eine Kontaktschicht vorhanden sein, die aber entfallen kann, wenn die Strominjektion durch ein leitfähiges Substrat 1 erfolgt. Die Dicke des Metallfilms 7 beträgt typisch zwischen 0,01 µm und 0,1 µm.

Die Kontakte 11, 12, 13 auf der Oberseite bzw. auf der der Schichtfolge abgewandten Unterseite des Substrates 1 sind jeweils auf dotierten Halbleitermaterialien aufgebracht. Der Kontakt 11 befindet sich in dem Ausführungsbeispiel der Fig. 1 auf dem mit der oberen Kontaktschicht 6 elektrisch leitend verbundenen Halbleitermaterial. Der seitlich zu dem Streifen mit der Schichtfolge angeordnete Bereich, auf dem der Kontakt 12 aufgebracht ist, und die Zentralschicht 4 sind dazu entgegengesetzt dotiertes Halbleitermaterial. Eine ggf. vorhandene untere Kontaktschicht besitzt eine Dotierung mit demselben Vorzeichen wie die obere Kontaktschicht 6. Die untere Kontaktschicht 2 besitzt ebenso wie das Substrat 1 eine Dotierung mit demselben Vorzeichen wie die obere Kontaktschicht 6. Um parasitäre Ströme zu vermeiden, können an verschiedenen Stellen mit unerwünschten pn-Übergängen zusätzliche Isolationsbereiche oder sperrende pn-Übergänge angeordnet sein, die der Übersichtlichkeit halber in Fig. 1 weggelassen sind.

Bei dem Ausführungsbeispiel der Fig. 1 kann im Materialsystem von GaAs z. B. das Substrat 1 GaAs sein, die Kontaktschicht 6 und die Zentralschicht 4 jeweils AlGaAs und die Abstimmschicht 3 und die aktive Schicht 5 jeweils GaAs. Die aktive Schicht 5 kann auch eine Quantum-well-Struktur sein mit einer Folge dünner Schichten unterschiedlichen Energiebandabstandes, in dem Ausführungsbeispiel z. B. Schichten aus abwechselnd GaAs und InGaAs. Die gegebenenfalls vorhandene Deckschicht 10 ist ebenfalls AlGaAs. Das Substrat 1 und die Kontaktschichten 6 (ggf. auch die Deckschicht 10) sind z. B. pleitend dotiert. Die Zentralschicht 4 ist in dem Fall n-leitend dotiert. Mögliche Zusammensetzungen sind z. B. für die Zentralschicht 4 (Al_{0,35}Ga_{0,65})As und für die Kontaktschicht 6 z. B. (Al_{0,3}Ga_{0,7})As. Typische Schichtdicken sind: untere Kontaktschicht z. B. 1000 nm, die Abstimmschicht 3 z. B. 250 nm, die Zentralschicht 4 z. B. 500 nm, die aktive Schicht 5 z. B. 90 nm, die obere Kontaktschicht 6 im Ausführungsbeispiel ohne Deckschicht z. B. 400 nm bis 1300 nm. Die in Fig. 4 eingezeichneten typischen Abmessungen der gitterförmigen Strukturierung der Oberfläche sind z. B. 1300 nm für die Länge Lg der Gitterperiode, 100 nm für die Höhe h der Strukturierung (d. h. die Differenz zwischen maximalem und minimalem Abstand des Metallfilms 7 von der aktiven Schicht 5), z. B. 25 nm für die Dicke d des Metallfilms 7 und z. B. zwischen 100 und 500 nm für die Dicke eines eventuell auf den Metallfilm 7 aufgebrachten Dielektrikums. Die Resonatorlänge beträgt z. B. 500 µm, die Länge des strukturierten Bereiches der Oberfläche in Längsrichtung des Resonators z. B. 100 µm.

Fig. 2 zeigt eine alternative Ausführungsform, bei der Spiegelschichten 19, 20 für die Ausbildung einer vertikalen Laserresonanz ober- bzw. unterhalb der Kontaktschichten 2, 6 angeordnet sind. Die obere Spiegelschicht 20 kann entfallen, wenn der Metallfilm 7 eine ausreichende Reflexionswirkung besitzt. Zwischen den Spiegelschichten 19, 20 sind wie in Fig. 1 übereinander die untere Kontaktschicht 2, die Abstimmschicht 3, die Zentralschicht 4, die aktive Schicht 5 und die obere Kontaktschicht 6 angeordnet. Mit den Pfeilen sind verschiedene durch Abstimmen der Wellenlänge mögliche Abstrahlrichtungen angedeutet. In Fig. 2 sind außerdem Detektoren D1, D2, ..., Dn, die in verschiedenen Abstrahlrichtungen angeordnet sind, eingezeichnet. Statt der Detektoren können Glasfasern oder Anschlüsse für Glasfasern vorgesehen sein, in die das von der Laserdiode emittierte Licht jeweils gerichtet werden kann.

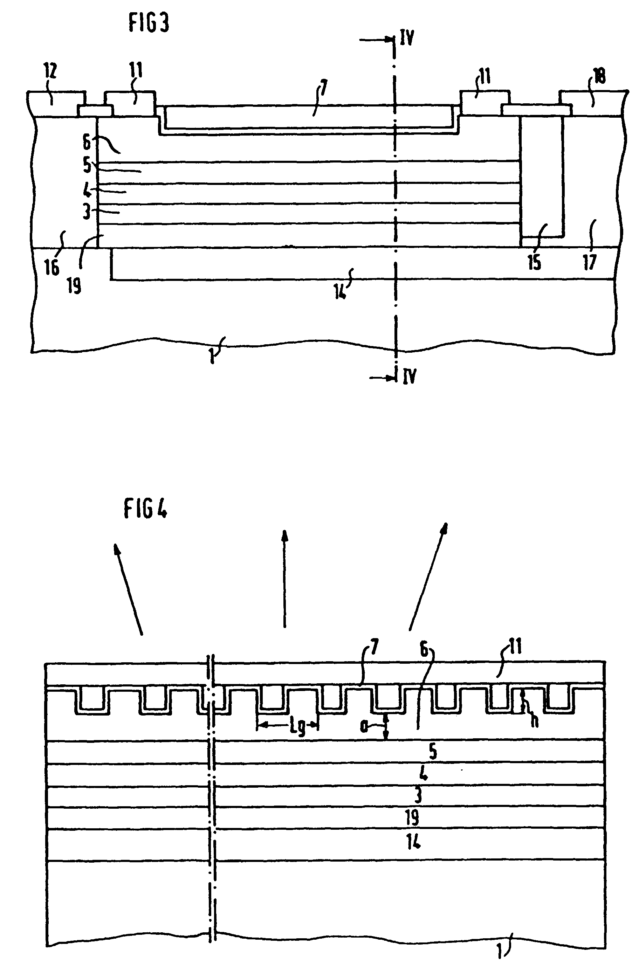

Für den für die Abstimmung vorgesehenen Teil der erfindungsgemäßen Laserdiode kommen im Prinzip alle Modifikationen, wie sie von der TTG-Laserdiode bekannt sind, in Frage. Als Beispiel ist in Fig. 3 eine Anordnung gezeichnet, bei der alle Kontakte auf der Oberseite angeordnet sind und das Substrat 1 semiisolierendes Material ist. Bei dieser Laserdiode ist außerdem beispielhaft ein vereinfachter Aufbau dargestellt, bei dem die Schichtfolge nur die untere Spiegelschicht 19, die Abstimmschicht 3, die Zentralschicht 4, die aktive Schicht 5 und die Kontaktschicht 6 umfaßt. Die räumliche periodische Strukturierung befindet sich unmittelbar in der Oberfläche dieser oberen Kontaktschicht 6. Alternativ zu der zweidimensionalen Strukturierung der Figuren 1 und 2 ist hier eine eindimensionale Strukturierung mit periodischer Abfolge in Längsrichtung des Laserstreifens gezeichnet. Eine derartige Strukturierung ist im Ausschnitt in einer perspektivischen Aufsicht in Fig. 6 dargestellt. Ein zu Fig. 3 gehörender Längsschnitt ist in Fig. 4 dargestellt. In Fig. 4 sind die Länge Lg der Periode der Struktierung, die Höhe h dieser Strukturierung und der minimale Abstand a des Metallfilmes 7 von der aktiven Schicht 5 eingezeichnet. Durch die Pfeile oberhalb sind wieder verschiedene Abstrahlrichtungen angedeutet.

Um eine getrennte Stromzuführung in die aktive Schicht 5 und in die Abstimmschicht 3 zu ermöglichen, ist in das semiisolierende Substrat 1 eine Zuführungsschicht 14 eingebettet, die z. B. durch Implantieren von Dotierstoff vor dem Überwachsen hergestellt wird. Der Kontakt 11 befindet sich unmittelbar auf der dotierten Kontaktschicht 6. Eine ggf. vorhandene untere Kontaktschicht ist für denselben Leitungstyp dotiert, ebenso die zuführungsschicht 14 und der darauf aufgebrachte laterale Bereich 17. Auf diesem lateralen Bereich 17 befindet sich ein Kontakt 18. Der Anschluß der entgegengesetzt dotierten Zentralschicht 4 erfolgt über den entsprechend dotierten zweiten lateralen Bereich 16, auf dem der Kontakt 12 aufgebracht ist. Auch bei Verwendung eines semiisolierenden Substrates stehen für die Schichtanordnung im einzelnen alle Modifikationen, die von TTG-Laserdioden auf semiisolierendem Substrat her bekannt sind, für die erfindungsgemäße Laserdiode zur Verfügung. So kann insbesondere die Laserdiode nach Fig. 3 durch ein DFB-Gitter oder eine obere Spiegelschicht zur Ausbildung eines Vertikalresonators ergänzt sein. Für die periodische Strukturierung der Oberfläche kommen alle dem Fachmann aus der zitierten EP-A-0 442 002 bekannten Ausführungsformen in Frage. Für die anhand der Figuren 1 bis 4 beschriebenen Ausführungsformen ist diese Strukturierung zusätzlich durch die Figuren 5 und 6 veranschaulicht. Die periodische Strukturierung kann durch parallel zueinander ausgerichtete Gräben gebildet sein, die bei einer Laserdiode mit Horizontalresonator nicht in der Ausbreitungsrichtung des Lichtes in dem Resonator verlaufen. Die Strukturierung kann in allen Richtungen in der Schichtebene der aktiven Schicht periodisch sein. Das ist z. B. bei einer kreuzweisen Anordnung von Gräben oder Stegen der Fall. Zwei Scharen parallel zueinander angeordneter Gräben oder Stege mit jeweils gleichen Abständen zu den nächstgelegenen Gräben bzw. Stegen sind z. B. senkrecht zueinander angeordnet. Als Periodenlänge im Sinn der Ansprüche sind dann die für die Eigenschaft der Oberflachenmoden charakteristischen Abmessungen aufzufassen, also die Längen der Periodizität in den zwei jeweils auf einer Schar von Gräben bzw. Stegen senkrecht stehenden Richtungen. In Fig. 5 ist auch das DFB-Gitter 8 eingezeichnet, wobei die frontale Ansicht senkrecht zur Zeichenebene in Fig. 5 der frontalen Ansicht senkrecht zur Zeichenebene in Fig. 1 entspricht. Die frontale Ansicht von Fig. 6 ist ein Ausschnitt aus Fig. 4. Die durch den Pfeil in Fig. 6 bezeichnete Blickrichtung liefert einen entsprechenden Ausschnitt aus Fig. 3.

Für die Strukturierung der aktiven Schicht 5 und der Abstimmschicht 3 stehen die einschlägigen Möglichkeiten offen. Insbesondere kann die Abstimmschicht 3 eine Quantum-well-Struktur aufweisen. Zur Anregung von Oberflachenmoden höherer Ordnung (Oberflächenplasmonpolaritonen) kann der Metallfilm 7 durch eine Dielektrikumschicht bedeckt sein.

Im Fall einer Laserdiode mit streifenförmigem Horizontalresonator, durch den eine Ausbreitungsrichtung des Lichtes in der Ebene der aktiven Schicht festgelegt ist, erfolgt die Emission durch Anregung von Oberflachenmoden in der Ebene, die durch diese Ausbreitungsrichtung und die Senkrechte auf die Schichtebene festgelegt ist, falls die Strukturierung der Oberfläche primär in der Ausbreitungsrichtung periodisch ist. Das ist z. B. bei einer Strukturierung durch Gräben oder Stege, die senkrecht zur Längsrichtung des Resonators verlaufen, der Fall. Ist die Strukturierung der Oberfläche demgegenüber gleichartig, aber gedreht, dann erfolgt die Abstrahlung in diejenige Ebene, die durch die Senkrechte auf die Schichtebene und durch die Richtung kürzester Periodizität der Strukturierung festgelegt ist, d. h. in eine entsprechend gedrehte Ebene. Über die Ausrichtung der Strukturierung der Oberfläche kann demnach relativ zu der Laserdiode eine Ausrichtung der durch Abstimmen der Wellenlänge ansteuerbaren Abstrahlrichtungen vorgenommen werden.

Die Bündelung der Strahlung, die bei Anregung von Oberflächenmoden ausgesendet wird, ist so gut, daß mit der erfindungsgemäßen Laserdiode eine genau definierte Abstrahlrichtung sehr gut eingehalten werden kann. Bereits durch eine geringe Änderung der Wellenlänge, d. h. mittels einer geringfügigen Änderung der entsprechenden Steuerspannung, kann eine deutliche Änderung der Abstrahlrichtung bewirkt werden. Kleine Spannungsänderungen rufen daher deutlich meßbare Winkelvariationen der Abstrahlrichtung hervor. Damit ist auf einfache Weise ein lichtemittierendes Bauelement mit elektrisch variierbarem Abstrahlwinkel realisierbar. Verschiedene Abstrahlrichtungen mit derselben Laserdiode sind realisierbar, ohne daß für jede Abstrahlrichtung entsprechende Vorkehrungen in dem strukturellen Aufbau der Laserdiode vorgenommen werden müssen oder sogar die Laserdiode als Ganzes gedreht werden müßte.

## Patentansprüche

1. Abstimmbare oberflächenemittierende Laserdiode mit Zwei durch eine Zentralschicht (4) getrennten Schichten (3,5), die parallel und bezüglich der Schichtebenen transversal zueinander angeordnet sind und aus Halbleitermaterialien mit unterschiedlichen Energiebandabständen bestehen, von denen eine als aktive Schicht (5) und die andere als Abstimmschicht (3) vorgesehen ist und die elektrisch leitend mit Kontakten (11, 12, 13; 18) derart verbunden sind, daß eine getrennte Strominjektion in die aktive Schicht (5) und in die Abstimmschicht (3) erfolgen kann,
mit einer räumlichen periodischen Strukturierung, die in einem bezüglich der Schichtebenen transversal zu einem für Strahlungserzeugung in der aktiven Schicht (5) vorgesehenen Bereich angeordneten Bereich der Oberfläche einer äußersten Halbleiterschicht vorhanden und zumindest teilweise mit einem Metallfilm (7) bedeckt ist, wobei die Höhe (h) dieser Strukturierung und die Länge (Lg) jeweils einer Periode dieser Strukturierung, der minimale Abstand (a) dieses Metallfilms (7) von der aktiven Schicht (5) und die Dicke (d) dieses Metallfilms (7) so bemessen sind, daß im Betrieb der Laserdiode an der der aktiven Schicht (5) abgewandten Oberfläche dieses Metallfilms (7) Oberflachenmoden durch in der aktiven Schicht (5) erzeugte Photonen angeregt werden, und
mit Mitteln zur Erzielung einer Laserresonanz, die mindestens eine parallel und bezüglich der Schichtebenen transversal zu der aktiven Schicht (5) angeordnete Spiegelschicht (19, 20) umfassen.

2. Laserdiode nach Anspruch 1,
bei der die Mittel zur Erzielung einer Laserresonanz ein DFB-Gitter (8), das parallel und bezüglich der Schichtebenen transversal zu der aktiven Schicht 85) angeordnet ist, umfassen.

3. Laserdiode nach Anspruch 1 oder 2,
bei der der Metallfilm (7) mit einer Dielektrikumschicht bedeckt ist.

## Claims

1. Tunable surface-emitting laser diode having two layers (3, 5) which are separated by a central layer (4), are arranged parallel and, with reference to the planes of the layers, transverse to one another and consist of semiconductor materials having different energy band gaps, of which one is provided as active layer (5) and the other as tuning layer (3) and which are connected in an electrically conductive fashion to contacts (11, 12, 13; 18) in such a way that a separate current injection into the active layer (5) and into the tuning layer (3) can be performed, having a spatial periodic structure which is present in a region, arranged with reference to the planes of the layers in a fashion transverse to a region provided for generating radiation in the active layer (5), of the surface of an outermost semiconductor layer and is covered at least partially with a metallic film (7), the height (h) of this structure and the length (Lg) of in each case one period of this structure, the minimum distance (a) of this metallic film (7) from the active layer (5), and the thickness (d) of this metallic film (7) being dimensioned such that during operation of the laser diode surface modes are excited by photons generated in the active layer (5) on the surface of this metallic film (7) averted from the active layer (5), and having means for achieving a laser resonance which comprise at least one reflective coating (19, 20) arranged parallel and with reference to the planes of the layers transverse to the active layer (5).

2. Laser diode according to Claim 1, in which the means for achieving a laser resonance comprise a DFB grating (8) which is arranged parallel and with reference to the planes of the layers transverse to the active layer (5).

3. Laser diode according to Claim 1 or 2, in which the metallic film (7) is covered by a dielectric layer.

## Revendications

1. Diode laser accordable à émission de surface comportant deux couches (3, 5) séparées par une couche centrale (4), qui sont disposées parallèlement et par rapport aux plans de couche transversalement l'une par rapport à l'autre et se composent de matériaux semi-conducteurs comportant différents écartements de bande d'énergie, dont l'une est prévue comme couche active (5) et l'autre comme couche d'accord (3) et qui sont reliées de façon conductrice aux contacts (11, 12, 13 ; 18) de telle manière qu'une injection de courant distincte peut avoir lieu dans la couche active (5) et dans la couche d'accord (3), avec une structure spatiale périodique, qui est présente dans une zone de la surface de la couche semi-conductrice la plus extérieure, zone disposée, relativement aux plans de couche, transversalement à une zone prévue pour une production de rayonnement dans la couche active (5) et est au moins partiellement recouverte d'une pellicule métallique (7), la hauteur (h) de cette structure et la longueur (Lg) d'une période respectivement de cette structure, l'écartement minimal (a) de cette pellicule métallique (7) de la couche active (5) et l'épaisseur (d) de cette pellicule métallique (7) étant mesurés de sorte que lors du fonctionnement de la diode laser, des modes de surface sont activés à la surface opposée à la couche active (5) de cette pellicule métallique (7) par des photons produits dans la couche active (5), et comportant des moyens pour l'obtention d'une résonance laser, qui comprennent au moins une couche à miroir (19, 20) disposée parallèlement et par rapport aux plans de couche transversalement à la couche active (5).

2. Diode laser selon la revendication 1, dans laquelle les moyens pour l'obtention d'une résonance laser comprennent une grille-DFB (8), qui est disposée parallèlement et par rapport aux plans de couche transversalement à la couche active (5).

3. Diode laser selon la revendication 1 ou 2, dans laquelle la pellicule métallique (7) est recouverte d'une couche diélectrique.
